# EUROPEAN PATENT APPLICATION

(11) **EP 1 475 821 A2**
(43) Date of publication of application: **10.11.2004**
(21) Application number: 04252639.2
(22) Date of filing: 06.05.2004
(51) Int. Cl.: H01L 21/00, H05B 3/14

(54) **Wafer heating apparatus having electrostatic adsorption function**

(30) Priority: 09.05.2003 JP 2003131946
(71) Applicant: Shin-Etsu Chemical Company, Ltd., Tokyo 100-0004 (JP)
(72) Inventor: Kano, Shoji Gunma Complex, Annaka-shi Gunma-ken (JP); Yamaguchi, Kazuhiro Gunma Complex, Annaka-shi Gunma-ken (JP); Satoh, Akira Gunma Complex, Annaka-shi Gunma-ken (JP); Kimura, Noboro Gunma Complex, Annaka-shi Gunma-ken (JP)
(74) Representative: Cooper, John

(57) **Abstract**

There is disclosed a wafer heating apparatus having an electrostatic adsorption function, comprising: heating elements; electrodes for electrostatic adsorption; a supporting substrate on which are formed the heating elements and the electrodes for electrostatic adsorption; and an insulator layer formed over the heating elements and the electrodes for electrostatic adsorption, wherein where a sheet resistance (Ω/□) in a surface direction of the insulator layer is A and a volume resistivity (Ω·cm) in a thickness direction of the insulator layer is B, a ratio of the sheet resistance to the volume resistivity (A/B) is 0.01 or more. Thus, there can be provided a wafer heating apparatus having an electrostatic adsorption function that has sufficient electrostatic adsorption power without causing dielectric breakdown when electrostatically adsorbing and heating wafers.

## Description

### BACKGROUND OF THE INVENTION

### Field of the Invention:

The present invention relates to a wafer heating apparatus having an electrostatic adsorption function, that can be used favorably for a semiconductor wafer heating process in semiconductor device production processes and inspecting processes that include a heating process.

### Description of the Related Art

In conventional semiconductor device production processes and the like, where a semiconductor wafer is heated, a metal wire wound heater (tantalum wire heater) has been used. However, when that type of heater was used, there was a problem of metal contamination to the semiconductor wafer. Therefore, in recent years using of a ceramic integrated-type wafer heating apparatus utilizing a ceramic thin film as a heating element (ceramic heater) has been proposed (see Japanese Patent Publication No. 33-3541).

Among ceramic heaters, where the wafers are heated in a process such as molecular beam epitaxy, CVD, sputtering, or the like, it is effective to use a composite ceramic heater consisting of pyrolytic boron nitride (PBN) and pyrolytic graphite (PG) with a high purity which does not generate out gas from a ceramic substrate and is excellent in a thermal shock resistance (see Japanese Patent Application Laid-open No. 63-241921). This composite heater, compared to the conventional tantalum wire heater, is easily installed in apparatuses and, because it does not cause such trouble as thermal deformation, breakage, short circuits, etc., is easy to use. In addition, because it is a planar heater, it has the advantage of easily being able to attain comparatively even heating.

In heating semiconductor wafers, in order to fix the semiconductor wafers on the heater, an electrostatic adsorption apparatus is used in a reduced pressure atmosphere. As the material for the electrostatic adsorption apparatus, a shift from resin to ceramic has accompanied the rise in temperature of the heating process (Japanese Patent Application Laid-Open Publication Nos. 52-67353 and 59-124140).

Also, recently, there has been proposed a wafer heating apparatus having an electrostatic adsorption function by combining a ceramic integrated-type wafer heating apparatus and an electrostatic adsorption apparatus. For example, apparatuses in which alumina is used as the insulator layer of the electrostatic adsorption apparatus have been used in low temperature areas such as etching processing (New Ceramics, Vol.7, pp.49-53, 1994), and apparatuses in which pyrolytic boron nitride is used as the insulator layer of the electrostatic adsorption apparatus have been used in high temperature areas such as CVD processing (Japanese Patent Application Laid-Open Publication Nos. 4-358074, 5-109876, 5-129210 and 5-152015).

Although electrostatic adsorption power, as described in New Ceramics, Vol 7, pp. 49-53, 1994, becomes stronger as the volume resistivity of the insulator layer of the electrostatic adsorption apparatus decreases, if the volume resistivity becomes too low the device fails due to a leakage current. For that reason, the volume resistivity of the insulator layer of the electrostatic adsorption apparatus is preferably between 10⁸ and 10¹⁸ Ω·cm, and in particular between 10⁹ and 10¹³ Ω·cm.

Depending on the shapes of the electrodes of the electrostatic adsorption apparatus to which a voltage is applied, electrostatic adsorption apparatuses are classified into the three types of single pole, dipole and comb-shaped electrode. Among these electrostatic adsorption apparatus, in contrast to the single pole type having a single internal electrode, wherein grounding of an object to be adsorbed is necessary, in the dipole type having a pair of internal electrodes and the comb-shaped electrode type formed with pairs of electrodes in a comb shape, because positive and negative voltages are applied one to each of two electrodes, it is not necessary to ground wafers that are being adsorbed. As a result, among electrostatic adsorption apparatuses for semiconductors the dipole type and the comb-shaped electrode type are often used.

In recent years, although ceramic electrostatic adsorption apparatus have been increasingly mounted in molecular beam epitaxy apparatuses, CVD apparatuses, and sputtering apparatuses, the demand for using these at high temperatures exceeding 500°C in the production processes of semiconductor devices has been increasing.

However, where alumina is used in the insulator layer of a wafer heating apparatus having an electrostatic adsorption function as described above, the resistance value becomes too low in the mid-high temperature region of 500°C to 650°C, causing the problem that failures of the devices are generated due to leakage currents.

Also, where pyrolytic boron nitride is used in the insulator layer of a wafer heating apparatus having an electrostatic adsorption function, there is the problem of sufficient electrostatic adsorption being unattainable due to the resistance value in the mid-high range described above being too high.

In order to solve such problems, wafer heating apparatuses have been proposed having sufficient electrostatic adsorption power with a moderate resistance value in the 500°C to 650°C mid-high temperature region, such as that using pyrolytic boron nitride containing carbon at 1 to 20 percent by weight in the insulator layer of the electrostatic adsorption apparatus (Japanese Patent Application Laid-Open Publication No. 9-278527) or that using pyrolytic boron nitride containing silicon at 1 to 10 percent by weight in the insulator layer of the electrostatic adsorption apparatus (Japanese Patent Application Laid-Open Publication No. 8-227933).

However, although it is necessary to apply a high voltage in order to adsorb wafers with the function of an electrostatic adsorption apparatus, there is the problem that as the temperature in the usage area rises a leakage current between a pair of electrodes of a dipole type electrostatic adsorption apparatus increases, and in the worst case the insulator layer causes a dielectric breakdown and the adsorption function is lost.

Also, where the insulator layer causes a dielectric breakdown, in order to replace this electrostatic adsorption apparatus it is necessary to stop the semiconductor device production process, leading to an increase in production costs.

### Summary of the invention

It is therefore the object of the present invention to provide a wafer heating apparatus having an electrostatic adsorption function that has sufficient electrostatic adsorption power without causing dielectric breakdown and can be used stably over long periods when electrostatically adsorbing and heating wafers, and solves the problem of wafer desorption during device production due to insufficient adsorption, and the conventional problem of an increase in cost due to stopping the semiconductor device producing equipment.

The inventors of the present invention, as a result of earnest investigations in order to solve the above problems, have found that if the ratio of the sheet resistance in the surface direction of the insulator layer to the volume resistivity in the thickness direction of the insulator layer is low, sufficient adsorption power can be attained and dielectric breakdown does not occur. And based on this knowledge, the present invention has been completed.

Namely, according to the present invention there is provided a wafer heating apparatus having an electrostatic adsorption function, comprising
heating elements; electrodes for electrostatic adsorption; a supporting substrate on which are formed the heating elements and the electrodes for electrostatic adsorption; and an insulator layer formed over the heating elements and the electrodes for electrostatic adsorption, wherein
where a sheet resistance (Ω/□) in a surface direction of the insulator layer is A and a volume resistivity (Ω·cm) in a thickness direction of the insulator layer is B, a ratio of the sheet resistance to the volume resistivity (A/B) is 0.01 or more.

According to the wafer heating apparatus of the present invention, it can be used stably over long periods in the mid-high temperature region without causing dielectric breakdown between the bipolar electrodes, and it is possible to solve the problem of wafer desorption during device production due to insufficient adsorption power, and the problem of increase in production cost due to stopping the semiconductor device producing equipment.

### BRIEF DESCRIPTION OF THE DRAWINGS

The above and other objects, aspects, features and advantages of the present invention will become more apparent from the following detailed description when taken in conjunction with the accompanying drawings, in which:
FIG. 1 is a schematic cross-sectional view illustrating a wafer heating apparatus of the present invention; and
FIG. 2 is a schematic cross-sectional view illustrating a method of measuring wafer adsorption power.

### DESCRIPTION OF THE INVENTION AND A PREFERRED EMBODIMENT

The present invention will now be described in detail with reference to the drawings.

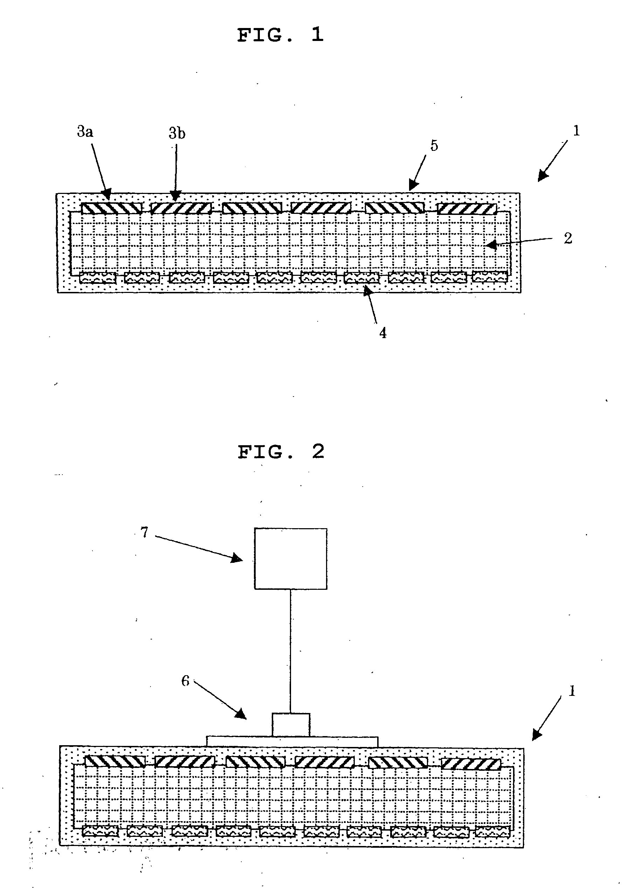

The structure of the wafer heating apparatus of the present invention is not particularly limited if the heating element and the electrodes for electrostatic adsorption are formed on the supporting substrate and the insulator layer is formed over the heating element and the electrodes for electrostatic adsorption. As a concrete example of the present invention, a wafer heating apparatus 1 is given having a structure in which heating elements 4 are formed on one surface of a supporting substrate 2, an insulator layer 5 is bonded thereon, electrodes for electrostatic adsorption 3a and 3b are formed on the other surface, and an insulator layer 5 is bonded thereon, as illustrated in the schematic cross-sectional view of FIG. 1.

The wafer heating apparatus of the present invention is characterized in that, where the sheet resistance (Ω/□) in the surface direction of the insulator layer is A and the volume resistivity (Ω·cm) in the thickness direction of the insulator layer is B at the temperature when a wafer is adsorbed, the ratio of the sheet resistance to the volume resistivity (A/B) is 0.01 or more. If the ratio is less than 0.01, electrostatic adsorption power is not generated and in the worst case, dielectric breakdown occurs between the electrodes of the dipole structure, and the problem of not being able to exercise the electrostatic adsorption function occurs. This is thought to be due to a reduction in electrostatic adsorption power resulting from an increase in a proportion of the leakage current passing directly through the insulator layer between the electrodes of the dipole structure and a decrease in the leakage current to the wafer contributing to wafer adsorption.

Consequently, by making the ratio of the sheet resistance to the volume resistivity (A/B) 0.01 or more, preferably 0.1 or more, sufficient electrostatic adsorption power is generated for practical purposes without causing dielectric breakdown between the dipole electrodes, and therefore, the above problem can be eliminated.

Also, the upper limit of the ratio of the sheet resistance to the volume resistivity (A/B), although not especially limited, is normally 100,000 or less, in particular 10,000 or less, this being preferable for the reason of ensuring dielectric strength between the electrodes and the wafer.

Means for changing/adjusting the above ratio of the sheet resistance to the volume resistivity (A/B) include, for example, adding/dispersing impurities into the insulator layer to impart anisotropy, subjecting to annealing to impart crystalline orientation, or, when the insulator layer is formed by means of a vapor phase growth method, changing kinds of the raw material gas, reaction temperature, reaction pressure, etc.

In the wafer heating apparatus of the present invention, it is preferable that the electrodes for electrostatic adsorption are comprised of bipolar electrodes in a paired bipolar structure, and formed in a comb shape or concentric circular. The adsorption power for the wafers is thereby stabilized.

The material for the electrodes for electrostatic adsorption is not especially limited, but can include, for example, pyrolytic graphite.

Also, in the wafer heating apparatus of the present invention, the supporting substrate is preferably formed using any one of a silicon nitride sintered body, a boron nitride sintered body, a mixed sintered body of boron nitride and aluminum nitride, an alumina sintered body, an aluminum nitride sintered body, pyrolytic boron nitride, and pyrolytic boron nitride coated graphite. The reason for this is that these materials have stable properties in the mid-high temperature region of 500°C to 650°C.

Further, in the supporting substrate, it is preferable that the electrodes for electrostatic adsorption are formed on one surface thereof, and the heating elements are formed on the other. The reason for this is that, where the electrodes for electrostatic adsorption and the heating elements are formed on the same surface, there is the danger of dielectric breakdown between the electrodes for electrostatic adsorption and heating elements.

The material for the heating elements, although particularly limited, can include for example pyrolytic graphite.

The material for the insulator layer is preferably comprised of any one of silicon nitride, boron nitride, a mixture of boron nitride and aluminum nitride, alumina, aluminum nitride, and pyrolytic boron nitride, with impurities added thereto within a range of 0.001 to 30 wt% and the volume resistivity adjusted to within the range of 10⁸ to 10¹⁸ Ω·cm. The insulator layer comprised of such a material has stable properties and exhibits sufficient electrostatic adsorption power in the mid-high temperature region of 500°C to 650°C. The above impurities can include Ti, TiN, Si, C, Y, A1, or the like.

Further, in the wafer heating apparatus of the present invention, at least one of the electrodes for electrostatic adsorption, the heating elements, and the insulator layer is preferably formed by chemical vapor deposition. By forming these by chemical vapor deposition, formation with a uniform predetermined thickness is possible, and generation of delaminating and particles can be prevented.

### Examples

Although the present invention will then be described in more detail by means of examples, the present invention is not limited to the following examples.

### (Examples 1 to 8 and Comparative Examples 1 to 3)

By reacting a mixed gas of ammonia and boron trichloride under the conditions of 1800°C and 100 Torr, on a graphite substrate having a diameter of 200mm and a thickness of 20mm, pyrolytic boron nitride is formed to manufacture a pyrolytic boron nitride coated graphite substrate (supporting substrate).

Next, methane gas is pyrolized on the supporting substrate under the conditions of 2200°C and 5 Torr, providing a pyrolytic graphite layer having a thickness of 100 µm on the supporting substrate. Then, the pyrolytic graphite layer is subjected to pattern processing so that electrodes for electrostatic adsorption are formed in a bipolar form alternately arranged in a concentric circle on one surface of the supporting substrate and heaters are formed on the other surface (back surface) to make the electrodes for electrostatic adsorption and the heating layer.

Subsequently, by reacting a mixed gas of ammonia, boron trichloride, and methane on both surfaces with changing the reaction temperature and reaction pressure within the ranges of 1900 to 2000°C and 1 to 200 Pa (refer to FIG. 1), an insulator layer having a thickness of 200 µm which is comprised of pyrolytic boron nitride containing carbon is provided.

Then, finally, the wafer adsorption surface is mirror polished to produce the wafer heating apparatuses having an electrostatic adsorption function (Examples 1 to 8 and Comparative Examples 1 to 3). Incidentally, the insulator layer of carbon-containing pyrolytic boron nitride can be produced with reference to the publicly known document (J. Appl. Phys., Vol. 65 (1989)) and Japanese Patent Application Laid-Open Publication No. 9-278527.

In wafer heating apparatuses with variously modified manufacturing conditions of the insulator layeres, after measuring the ratio of the sheet resistance (Ω/□) in the surface direction to the volume resistivity (Ω·cm) in the thickness direction of the insulator layer, that is (sheet resistance/volume resistivity), a wafer is adsorbed by applying a voltage of ±500V between the dipolar electrodes in a state where the temperature was increased to 650°C, and the adsorption power at that time was measured with respect to each wafer heating apparatus (Examples 1 to 8 and Comparative Examples 1 to 3).

Incidentally, measurements of the sheet resistance in the surface direction and the volume resistivity in the thickness direction of the insulator layer are performed according to JIS standard (K6911-1995 5.13 resistivity). Also, measurement was performed using a Hiresta IP MCP-HT260 (product name) made by Dia Instruments Co., Ltd. as a measuring machine and an HRS probe as a probe, under an atmosphere of a room temperature and humidity of 50% around the center of the wafer heating apparatus having an electrostatic adsorption function.

The measurement of wafer adsorption power is performed by pulling an adsorbed silicon jig 6 upward in a vacuum (10Pa) as shown in FIG. 2, and the value of a load cell 7 when the jig 6 separates is taken as the adsorption power.

The measurement results of Examples 1 to 8 and Comparative Examples 1 to 3 have been assembled in Table 1. As seen from Table 1, if the ratio of the sheet resistance in the surface direction to the volume resistivity in the thickness direction of the insulator layer is less than 0.01, adsorption power was not significantly generated, and dielectric breakdown was caused in some cases (Comparative Example 3). On the other hand, if the above ratio is 0.01 or more, sufficient adsorption was generated and dielectric breakdown did not occur.

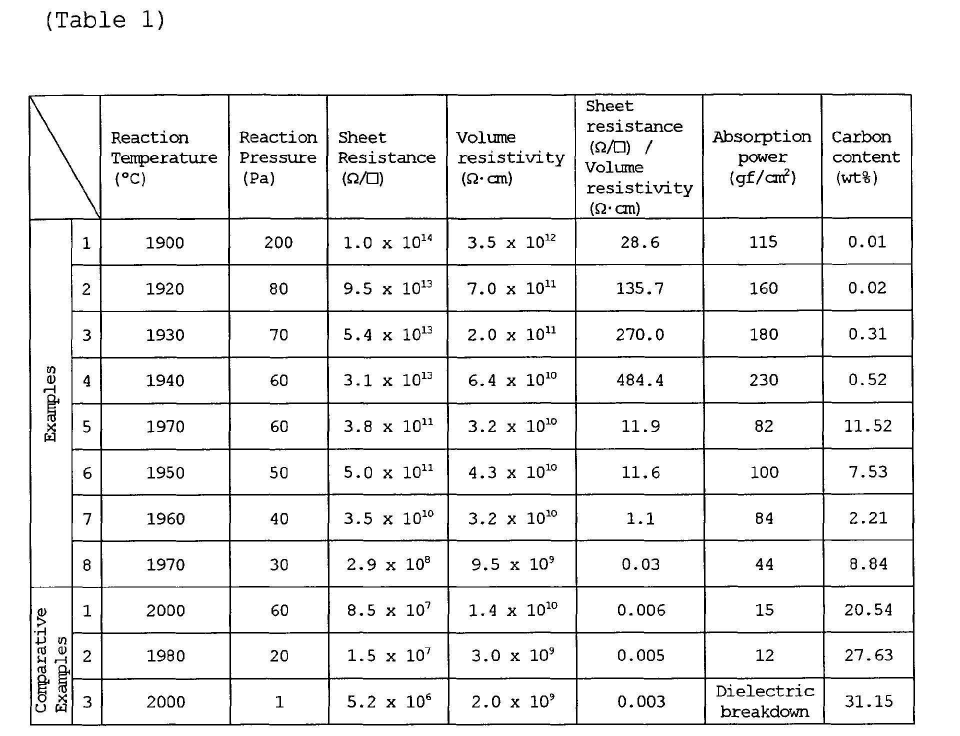

While illustrative and presently preferred embodiments of the present invention have been described in detail herein, it is to be understood that the inventive concepts may be otherwise variously embodied and employed and that the appended claims are intended to be construed to include such variations except insofar as limited by the prior art.

## Claims

1. A wafer heating apparatus having an electrostatic adsorption function, comprising:
heating elements;
electrodes for electrostatic adsorption;
a supporting substrate on which are formed the heating elements and the electrodes for electrostatic adsorption; and
an insulator layer formed over the heating elements and the electrodes for electrostatic adsorption, wherein
where a sheet resistance (Ω/□) in a surface direction of the insulator layer is A and a volume resistivity (Ω·cm) in a thickness direction of the insulator layer is B, a ratio of the sheet resistance to the volume resistivity (A/B) is 0.01 or more.

2. The wafer heating apparatus according to claim 1, wherein the electrodes for electrostatic adsorption are comprised of bipolar electrodes having a paired bipolar structure, and formed in a comb shape or a concentric circular.

3. The wafer heating apparatus according to claim 1 or 2, wherein the supporting substrate is formed using any one of a silicon nitride sintered body, a boron nitride sintered body, a mixed sintered body of boron nitride and aluminum nitride, an alumina sintered body, an aluminum nitride sintered body, pyrolytic boron nitride, and pyrolytic boron nitride coated graphite.

4. The wafer heating apparatus according to any one of claims 1 to 3, wherein the electrodes for electrostatic adsorption are formed on one surface of the supporting substrate, and the heating elements are formed on the other surface.

5. The wafer heating apparatus according to any one of claims 1 to 4, wherein the insulator layer is comprised of any one of silicon nitride, boron nitride, a mixture of boron nitride and aluminum nitride, alumina, aluminum nitride, and pyrolytic boron nitride, with impurities added thereto within a range of 0.001 to 30 wt%, and the insulator layer has a volume resistivity within the range of 10⁸ to 10¹⁸ Ω·cm.

6. The wafer heating apparatus according to any one of claims 1 to 5, wherein at least one of the electrodes for electrostatic adsorption, the heating elements, and the insulator layer is formed by chemical vapor deposition.
